# EUROPEAN PATENT APPLICATION

(11) **EP 1 353 372 A1**
(43) Date of publication of application: **15.10.2003**
(21) Application number: 02715818.7
(22) Date of filing: 18.01.2002
(51) Int. Cl.: H01L 21/8247, H01L 29/788, H01L 29/792, H01L 27/115

(54) **NONVOLATILE SEMICONDUCTOR MEMORY DEVICE AND ITS MANUFACTURING METHOD**

(30) Priority: 19.01.2001 JP 2001012442
(71) Applicant: Sony Corporation, Tokyo 141-0001 (JP)
(72) Inventor: SUZUKI, Toshiharu, c/o SONY CORPORATION, Tokyo 141-0001 (JP)
(74) Representative: Müller, Frithjof E., Dipl.-Ing.
(86) International application number: JP0200342
(87) International publication number: WO02058136

(57) **Abstract**

In a non-volatile semiconductor memory device, the device is miniaturized by increasing the coupling ratio between a floating gate and a control gate electrode and reducing the write voltage. In a non-volatile memory device (a so-called floating gate type flash memory 300)) having a floating gate electrode FG in an insulation film (a tunnel oxide film (4), an ONO film structure (9)) between a semiconductor layer (a Si substrate (1)) and a control gate electrode CG, wherein charge is accumulated in the floating gate electrode FG, thereby causing a change in the threshold voltage of a transistor, and thus storing data, the floating gate electrode FG faces substantially the entire surfaces of a bottom surface and a side of the control gate electrode CG via the insulation film (the ONO film structure (9)).

## Description

### TECHNICAL FIELD

The present invention relates to a non-volatile semiconductor memory device which is a data memory device used in an MIS type LSI, and which is also capable of storing data regardless of whether the device's power is on or off.

### BACKGROUND ART

In an MIS type LSI, numerous non-volatile semiconductor memory devices which are capable of storing data regardless of whether the device's power is on or off are used. Various types of non-volatile semiconductor memory devices are known, and so-called floating gate type flash memories, in which a floating gate electrode comprising poly-Si or the like is provided in the middle of a gate insulation film of an MIS structure, electric charge is injected from the Si substrate into the floating gate electrode via an insulation film between the Si substrate and the floating gate electrode by means of hot carriers, a tunnel current or the like, and the floating gate electrode is charged thereby changing the threshold voltage of an MIS type transistor and storing in memory, are put to practical use.

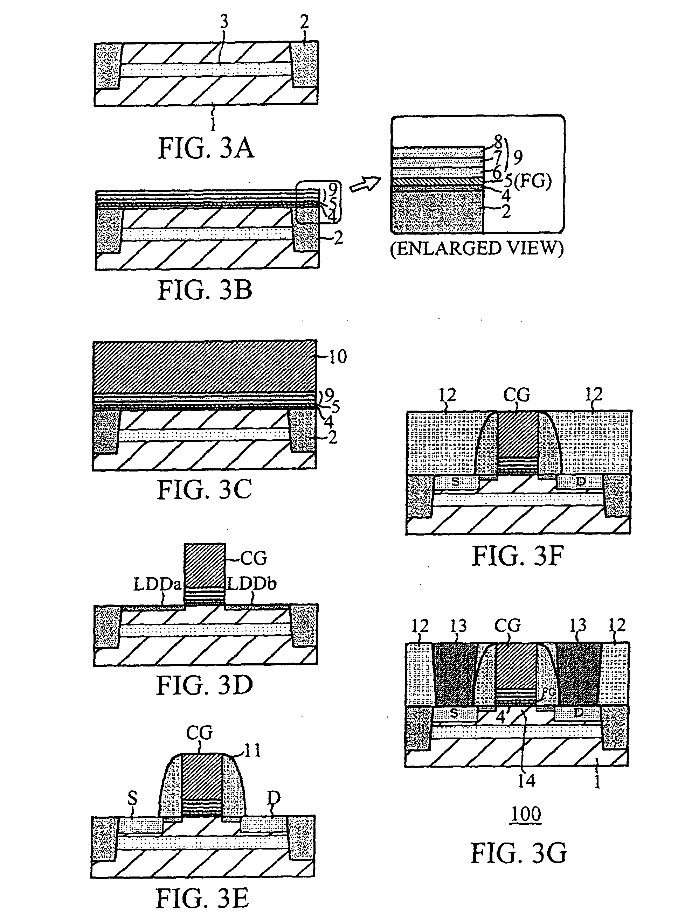

A floating gate type flash memory is manufactured as shown in Fig. 3A to Fig. 3G. At first, a well isolation or isolation region 2 is formed on a Si substrate 1 by way of ordinary LOCOS methods, shallow trench methods or the like, and an embedding layer 3 to adjust a threshold voltage is formed using the ion implantation method (Fig. 3A).

Subsequently, a Si oxide film (tunnel oxide film) 4 having a thickness of about 8nm is formed on this substrate through thermal oxidation at about 800°C for 15 minutes, and a poly-Si film 5 having a thickness of about 6nm which is to become a floating gate electrode FG is formed thereon through LP-CVD, plasma CVD or the like. Next, through thermal oxidation at about 850°C for 10 minutes, the surface of the poly-Si film 5 is made a Si oxide film 6 having a thickness of about 5nm, and thereon a Si nitride film (Si₃N₄) 7 having a thickness of about 12nm is formed through LP-CVD, plasma CVD or the like. Then, by performing thermal oxidation on the Si nitride film 7 to form a Si oxide film 8 having a thickness of about 6nm, an ONO film structure 9 comprising the Si oxide film 6, the Si nitride film 7 and the Si oxide film 8 is formed (Fig. 3B).

A poly-Si and WSi layered film 10 containing phosphorus or the like at a high concentration, which is to become a control gate electrode CG, is formed on this ONO film structure 9 (Fig. 3C). This is patterned by using ordinary lithography and RIE techniques, thereby forming the control gate electrode CG. Then, with the control gate electrode CG as a mask, phosphorus or arsenic, for example, is ion implanted at a concentration of about 5 × 10¹³/cm² to thereby form low concentration regions LDDₐ and LDD_{b} (Fig. 3D).

Next, by way of ordinary CVD and etch-back methods, a side wall 11 of the control gate electrode CG is formed using a Si oxide film, and with this as a mask, phosphorous or the like, for example, is ion implanted at a concentration of about 5 × 10¹⁵/cm² to thereby introduce impurities of a source S and a drain D. Then, in order to activate these impurities, a thermal treatment at about 900°C for 30 minutes is performed through electric furnace heating, or a thermal treatment at about 1050°C for 10 seconds is performed with a Rapid Thermal Processing (RTP) apparatus (Fig. 3E).

Next, an interlayer insulation film 12, such as a Si oxide film or the like, is formed (Fig. 3F), and a connection hole is opened to form a plug 13 comprising W, poly-Si or the like. Consequently, a floating gate type flash memory 100 comprising an n-MIS type transistor is obtained (Fig. 3G).

When writing in the floating gate type flash memory 100, a voltage of about +20V is applied to the control gate electrode CG in a condition where the Si substrate 1 is grounded, for example. Then, charge (electrons) is injected into the floating gate electrode FG from a channel region 14 of the Si substrate 1 by a tunnel current. The charge accumulated in the floating gate electrode FG is still accumulated in the floating gate electrode FG even after the voltage falls below the write voltage of 20V. In this accumulated state, because the threshold voltage (Vth) of the n-MIS type transistor is high in value, an off state is maintained regardless of whether the power of the transistor is on or off. As a result, the floating gate type flash memory 100 functions as a non-volatile semiconductor memory device.

However, in the floating gate type flash memory 100 in Figs. 3A to 3G, if there is even a partial leak in the tunnel oxide film 4 between the floating gate electrode FG and the Si substrate 1, all of the charge accumulated in the floating gate electrode FG is lost, and it is thus extremely difficult to make the tunnel oxide film 4 thinner. As a result, the data write voltage can not be reduced to or below approximately 18V, it becomes difficult to miniaturize the structure of the corresponding drain D and the like, and its application as a micro non-volatile semiconductor memory device to follow the 0.13µm generation is considered difficult.

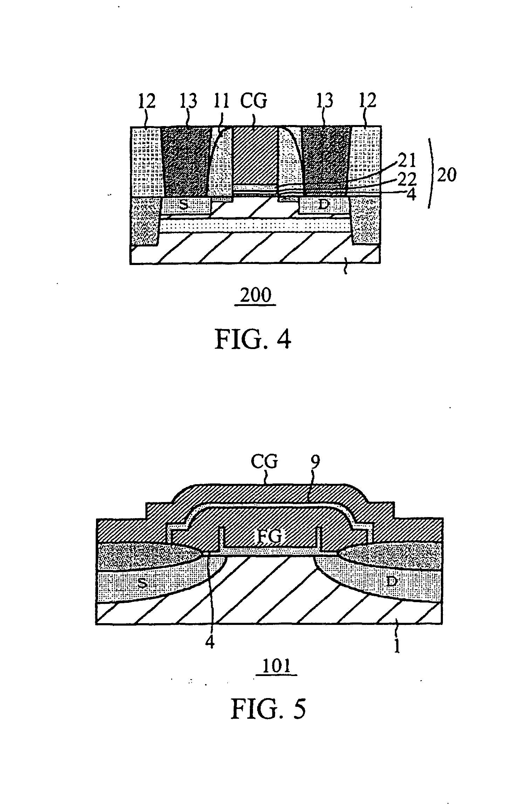

On the contrary, as shown in Fig. 4, also developed is a so-called MONOS type flash memory 200, in which a MONOS structure 20, comprising metal (a control gate electrode CG), a Si oxide film 21, a Si nitride film 22, a Si oxide film (tunnel oxide film) 4 and a Si substrate 1, is formed, charge is accumulated in discrete traps existing in the Si nitride film 22 and close to the interface between the Si oxide film 21 and the Si nitride film 22, and data is thereby stored by changing the threshold of a transistor. With the MONOS type flash memory 200, since charge is accumulated in the discrete traps, even if there is a partial leak in the tunnel oxide film 4, a large part of the accumulated charge will not be lost. Thus, the film thickness of the tunnel oxide film 4 can be reduced to about 3 nm, which is considerably thinner relative to the floating gate type flash memory 100. Consequently, this has the potential for reducing the write voltage to or below 10V.

However, the charge density which may be accumulated in the traps of the MONOS type flash memory 200 is lower by about five figures than the floating gate type flash memory 100. Also, it is not easy to reproducibly and controllably form the trap density of the MONOS type flash memory 200. For this reason, in the miniaturized MONOS type flash memory 200, the data retention and write/erase repetition endurance are not always sufficient.

On the other hand, in order to increase the ratio of the capacitances of a floating gate and a control gate with regard to the entire capacitance related to the floating gate (capacitive coupling ratio or coupling ratio), there is known a floating gate type flash memory 101 in which, as shown in Fig. 5, an ONO film structure 9 is formed so as to cover a side wall and a top surface of a floating gate electrode FG in its isolation direction, and a control gate electrode CG is formed so as to cover a side and a top surface of that ONO film structure 9 (Y.S.Hisamune et al., IEDM Tech,, Digest '93, p19 (1993)).

However, in order to increase the capacitive coupling ratio (coupling ratio) in this floating gate type flash memory 101, the film thickness of the floating gate electrode FG must be thickly formed, and the width of the control gate electrode CG also becomes wider, which is not suitable for miniaturization. Also, there is a disadvantage in that forming a plug becomes more difficult.

The present invention aims to provide a new non-volatile memory device, which, compared to such conventional non-volatile memory devices mentioned above, has a high electric capacitive coupling ratio (coupling ratio), is capable of reducing write voltage, and is suitable for miniaturization.

### DISCLOSURE OF THE INVENTION

The present inventor has found that (1) one of the reasons the write voltage can not be reduced in conventional floating gate type flash memories is that because the ratio of the capacitance (coupling ratio) between the control gate electrode and the floating gate electrode with regard to the entire capacitance related to the floating gate electrode is low, most of the voltage applied to the control gate electrode is applied between the control gate electrode and the floating gate electrode, and, in effect, is not applied to the tunnel oxide film between the floating gate electrode and the Si substrate, and (2) therefore, by increasing this coupling ratio, the voltage applied to the tunnel oxide film can, in effect, be increased to thereby reduce the write voltage, and (3) in order to increase the coupling ratio, it is effective to form a gate trench using a dummy gate method, and then form the floating gate electrode not only on the bottom surface inside the gate trench but also on the sides therein.

In other words, the present invention provides a non-volatile semiconductor memory device comprising a floating gate electrode in an insulation film between a semiconductor substrate and a control gate electrode, and characterized in that accumulation of charge in the floating gate electrode causes the threshold voltage of a transistor to change, and data is stored, and wherein the floating gate electrode faces both the bottom surface and the sides of the control gate electrode via the insulation film.

Also, the present invention provides a method of manufacturing this non-volatile semiconductor memory device in which a floating gate electrode faces both the bottom surface and the sides of a control gate electrode via an insulation film, by forming a dummy gate on a semiconductor substrate, further forming a side wall comprising the insulation film around the dummy gate, etching and removing the dummy gate to form a gate trench, sequentially film forming the floating gate electrode layer and an insulation film on the insulation film of the bottom surface and the side wall of the gate trench, and further film forming a control gate electrode layer and embedding it in the gate trench.

### BRIEF DESCRIPTION OF THE DRAWINGS

Figs. 1A to 1I are manufacturing process views of a floating gate type flash memory of the present invention ;
Figs. 2A, 2B are a plan view (a) and a sectional view (b) of a floating gate type flash memory of another embodiment of the present invention
Figs. 3A to 3G are manufacturing process views of a conventional floating gate type flash memory ;
Fig. 4 is a sectional view of a MONOS type flash memory ; and
Fig. 5 is a sectional view of a conventional floating gate type flash memory.

### BEST MODES FOR CARRYING OUT THE INVENTION

The present invention will be described below in detail with reference to the drawings. It is to be noted that in the respective drawings, like symbols indicate identical or equivalent elements.

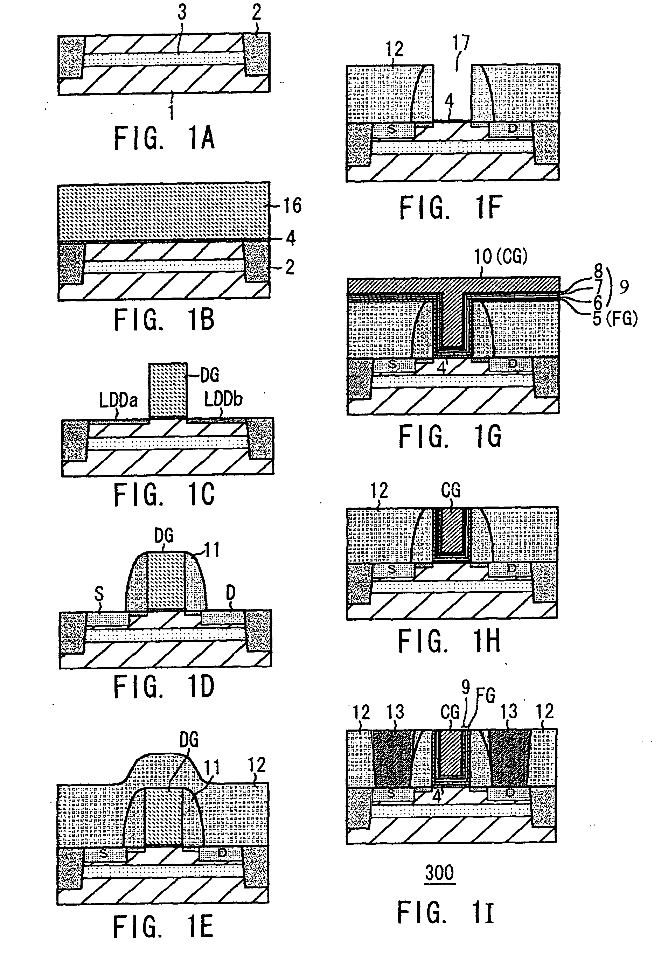

Figs. 1A to 1I are views of an example of a manufacturing process for a floating gate type flash memory of the present invention.

First, a well isolation or isolation region 2 is formed on a Si substrate 1 using a typical LOCOS method, a shallow trench method or the like, and an embedding layer 3 for adjusting the threshold voltage is formed using the ion implantation method (Fig. 1A).

Next, a Si oxide film (tunnel oxide film) 4 having a thickness of about 7 to 9 nm is formed on this substrate by thermal oxidation at about 800 to 850 °C for 10 to 15 minutes, and a poly-Si film 16 having a thickness of about 500 to 700 nm which becomes a dummy gate DG is formed thereon through LP-CVD or the like (Fig. 1A).

By performing patterning on this layered structure using lithography and RIE techniques, the dummy gate DG is formed, and by ion implanting, for example, phosphorus or arsenic at a concentration of approximately 5 × 10¹³/cm² with this dummy gate DG as a mask, low concentration regions LDDₐ and LDD_{b} are formed (Fig. 1C).

Next, typical CVD and etch-back methods are used to form a side wall 11 to the dummy gate DG. With this as a mask, for example, phosphorous or the like is ion implanted at a concentration of about 5 × 10¹⁵/cm² to introduce the impurities of a source S and a drain D. Then, in order to activate them, a thermal treatment at about 850 to 950°C for 20 to 30 minutes is carried out through electric furnace heating, or a thermal treatment at about 1000 to 1100°C for 5 to 10 seconds is carried out by a Rapid Thermal Processing (RTP) apparatus (Fig. 1D).

Next, by depositing a Si oxide film or the like, an interlayer insulation film 12, which covers the dummy gate DG and the periphery thereof, is formed (Fig. 1E). Then, the interlayer insulation film 12 is planarized by a planarization technique such as CMP or the like to expose the dummy gate DG. The exposed dummy gate DG is removed using an etching method, and a gate trench 17 is formed (Fig. 1F). The tunnel oxide film 4 serving as a foundation for the dummy gate DG may be left after the etching of the dummy gate DG, or may be removed by etching following the removal of the dummy gate DG. If the tunnel oxide film 4 is removed, the tunnel oxide film 4 is formed again on the bottom surface of the gate trench 17.

Next, a poly-Si film 5, which becomes a floating gate electrode FG, is deposited to have a film thickness of about 6 to 8nm on the entire surface of the side wall and the bottom surface within the gate trench 17. As a method of forming this poly-Si film 5, LP-CVD, plasma CVD or the like may be used, however, in order to make the film thickness uniform, it is preferable to use Atomic Layer Chemical Vapor Deposition (ALCVD).

Next, by forming a Si oxide film 6 having a thickness of about 4.5 to 5.5nm through thermally oxidizing the surface of the poly-Si film 5, forming a Si nitride film (Si₃N₄) 7 having a thickness of about 11 to 13nm thereon, performing thermal oxidation on the Si nitride film 7 to form a Si oxide film 8 having a thickness of about 5 to 7nm, an ONO film structure 9 comprising the Si oxide film 6, the Si nitride film 7 and the Si oxide film 8 is formed. In this process of forming the ONO film structure 9, the Si nitride film 7 may be formed by way of LP-CVD, plasma CVD or the like., however, in order to form an ultra thin film in a film thickness that is almost absolutely uniform relative to the substrate shape of the foundation, and particularly in order to form a continuous film with a stable film thickness even at corner portions of the gate trench 17, the use of Atomic Layer Chemical Vapor Deposition is preferred. Also, in order to form the ONO film structure 9 in continuous films having a still more uniform film thickness and to reduce the write voltage, it is preferable to form not only the Si nitride film 7, but also each of the Si oxide film 6, the Si nitride film 7 and the Si oxide film 8 using a high temperature CVD method (700 to 800°C). Moreover, it is further preferable that they be formed through Atomic Layer Chemical Vapor Deposition.

By embedding the gate trench 17 through forming a layered film 10 of poly-Si and WSi containing phosphorus or the like at a high concentration on the entire surface including the gate trench 17, a control gate electrode CG is formed (Fig. 1G).

Next, by planarizing them, the layered film 10, the ONO film structure 9 and the poly-Si film 5 in the outer region of the gate trench 17 are removed (Fig. 1H). Then, a connection hole is opened in the interlayer insulation film 12 to form a plug 13 comprising W, poly-Si or the like, and a floating gate type flash memory 300 of an embodiment of the present invention is obtained (Fig. 1I).

In the floating gate type flash memory 300 thus formed, the floating gate electrode FG faces the control gate electrode CG not only at the bottom surface of the control gate electrode CG but also across the side. Thus, it is coupled at a large capacitance. For example, in a typical floating gate type flash memory of the 0.18µm generation, because the Si oxide film converted film thickness of the ONO film structure 9 above the floating gate electrode FG is about 14.4nm, if the gate length is 0.18µm, the gate width 1.0µm, the gate height 0.6µm, in a conventional floating gate type flash memory shown in Figs. 3A through 3G, the capacitive ratio (coupling ratio) between the control gate electrode CG and the floating gate electrode FG with regard to the entire capacitance related to the floating gate electrode, is about 0.56, if the capacitances of the floating gate and the connection plug are disregarded. However, in the floating gate type flash memory 300 of the present invention in Figs. 1A to 1I, it is about 10.9, and the coupling ratio can be improved by a factor of approximately 20. Hence, where a write voltage of 20V is required in the conventional floating gate type flash memory 100 shown in Figs. 3A to 3G, the floating gate type flash memory 300 of Figs. 1A to 1I only requires a write voltage of about 7.8V. Therefore, it is possible to significantly reduce the drain blocking voltage of a transistor constituting a floating gate type flash memory, and the device may be miniaturized.

The present invention may assume various modes. For example, in the floating gate type flash memory 300 of Figs. 1A to 1I, the floating gate electrode FG is not limited to the poly-Si film 5, but may also be a TiN film, whose film forming technique is well established, formed of TiCl₄ and NH₃ through Atomic Layer Chemical Vapor Deposition. In forming the floating gate electrode FG with a TiN film, an insulation film between this TiN film and the control gate electrode CG should preferably be formed highly reliably as a continuous film having a uniform film thickness through a CVD method or Atomic Layer Chemical Vapor Deposition.

Also, as the Si substrate serving as a foundation of the tunnel oxide film 4, it is possible to use a semiconductor substrate such as a silicon single crystal wafer or the like, or an arbitrary substrate on which an epitaxial silicon layer, a poly-silicon layer, an amorphous silicon layer or the like is formed. Moreover, the semiconductor substrate may comprise Si-Ge or the like, besides silicon as mentioned above, and they are broadly embraced in the semiconductor substrate of the present invention.

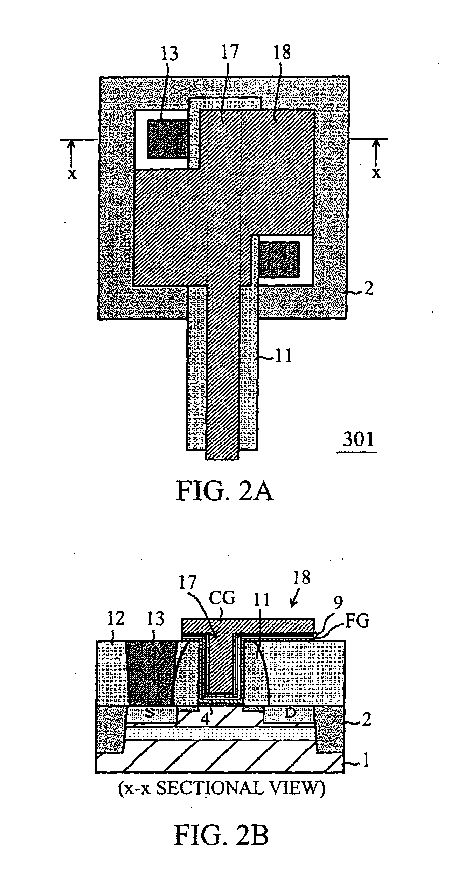

Moreover, in the floating gate type flash memory of the present invention, a projecting electrode 18, in which the floating gate electrode FG, the ONO film structure 9 and the control gate electrode CG projects in a planar shape outside the gate trench 17, as in a floating gate type flash memory 301 shown in Figs. 2A and 2B, may be formed.

The method of manufacturing the floating gate type flash memory 301 having this projecting electrode 18 is similar to that of the floating gate type flash memory 300 shown in Figs. 1A to 1I up to the embedding of the layered film 10, which constitutes the control electrode, into the gate trench 17 (Fig. 1G). Subsequently, the planar projecting electrode 18 is formed using lithography and etching techniques, and finally a connection hole is opened in the interlayer insulation film 12 and the plug 13 is filled.

Although thus providing the projecting electrode 18 causes the number of manufacturing processes to increase as compared with the floating gate type flash memory 300 in Figs. 1A to 1I, it is possible to further increase the ratio of capacitances (coupling ratio) between the control gate electrode CG and the floating gate electrode FG, with respect to the entire capacitance related to the floating gate electrode, and the write voltage may be further reduced.

According to the floating gate type flash memory of the present invention, because the floating gate electrode and the control gate electrode face each other not only at the bottom surface of the control gate electrode but also at the side, the accumulation capacitance of charge to the floating gate electrode is large, and the write voltage may be reduced. Also, this reduction in write voltage enables a reduction in the drain voltage of the transistor constituting the floating gate type flash memory. Hence, the transistor may be miniaturized.

In particular, if the insulation film between the floating gate electrode and the control gate electrode is formed through Atomic Layer Chemical Vapor Deposition, because it can be continuously formed with a uniform film thickness across the side and the bottom surface of the gate trench, the write voltage may be reduced in a further stable manner.

## Claims

1. A non-volatile semiconductor memory device comprising a floating gate electrode in an insulation film between a semiconductor substrate and a control gate electrode, **characterized in that** it is a non-volatile semiconductor memory device in which an accumulation of charge in said floating gate electrode causes a threshold voltage of a transistor to change, and data is thereby stored, and in which said floating gate electrode faces both a bottom surface and a side of said control gate electrode via said insulation film.

2. The non-volatile semiconductor memory device according to claim 1, wherein said insulation film between said control gate electrode and said floating gate electrode is formed across substantially the entire surface of said bottom surface and said side of said control gate electrode in a uniform thickness.

3. The non-volatile semiconductor memory device according to claim 2, wherein said insulation film between said control gate electrode and said floating gate electrode comprises a layered film of a Si oxide film, a Si nitride film and a Si oxide film formed through Atomic Layer Chemical Vapor Deposition.

4. In a method of manufacturing a non-volatile semiconductor memory device comprising a floating gate electrode in an insulation film between a semiconductor substrate and a control gate electrode, and in which, by accumulating charge in said floating gate electrode, a threshold voltage of a transistor changes and data is stored, said method of manufacturing a non-volatile semiconductor memory device, comprising forming a dummy gate on a semiconductor layer, forming a side wall comprising an insulation film on the periphery of said dummy gate, forming a gate trench by etching and removing said dummy gate, sequentially film forming said floating gate electrode and an insulation film on said insulation film on a bottom surface of a gate trench and on a side of said gate trench, film forming a control gate electrode layer, and embedding it in said gate trench such that said floating gate electrode faces both said bottom surface and said side of said control gate electrode via said insulation film.

5. The method of manufacturing a non-volatile semiconductor memory device according to claim 4, wherein said insulation film formed on said floating gate electrode layer is formed in a uniform thickness across substantially the entire surface of said bottom surface and said side wall of said gate trench.

6. The method of manufacturing a non-volatile semiconductor memory device according to claim 5, wherein a layered film of a Si oxide film, a Si nitride film and a Si oxide film is formed through Atomic Layer Chemical Vapor Deposition as said insulation film formed on said floating gate electrode layer.
